# FASCICULE DE BREVET EUROPEEN

(11) **EP 3 676 623 B1**
(45) Date de publication et mention de la délivrance du brevet: **15.01.2025**
(21) Numéro de dépôt: 18752724.7
(22) Date de dépôt: 03.08.2018
(51) Int. Cl.: G01R 31/08

(54) **IDENTIFICATION D'ANOMALIE DANS UN RÉSEAU DE DISTRIBUTION ÉLECTRIQUE**
ANOMALIEIDENTIFIZIERUNG IN EINEM ELEKTRISCHEN VERTEILUNGSNETZWERK
ANOMALY IDENTIFICATION IN AN ELECTRICAL DISTRIBUTION NETWORK

(30) Priorité: 28.08.2017 FR 1757920
(43) Date de publication de la demande: 08.07.2020
(73) Titulaire: Enedis, 92079 Paris La Defense Cedex (FR)
(72) Inventeur: CHAUVENET, Cédric, 92310 Sevres (FR); E SILVA, Cédric, 17340 Châtelaillon-Plage (FR)
(74) Mandataire: Plasseraud IP
(86) Numéro de dépôt international: PCT/EP2018/071145
(87) Numéro de publication internationale: WO 2019/042706

(56) Documents cités:
- FR-A1- 2 921 533
- FR-A1- 3 036 906
- US-A1- 2008 320 133
- US-A1- 2012 188 095
- JAN VAN DE VYVER ET AL: "The need for a distributed algorithm for control of the electrical power infrastructure", COMPUTATIONAL INTELLIGENCE FOR MEASUREMENT SYSTEMS AND APPLICATIONS, 2 003. CIMSA '03. 2003 IEEE INTERNATIONAL SYMPOSIUM ON 29-31 JULY 2003, PISCATAWAY, NJ, USA,IEEE, 29 July 2003 (2003-07-29), pages 211 - 215, XP010655264, ISBN: 978-0-7803-7783-7

## Description

L'invention relève du domaine de la gestion d'un réseau de distribution électrique.

Il est de la responsabilité d'un gestionnaire d'un réseau de distribution électrique de surveiller le bon fonctionnement du réseau. Des mesures préventives, notamment l'entretien, permettent de limiter les risques de dysfonctionnement. Des mesures curatives, notamment les interventions d'opérateurs sur le terrain, permettent de réduire la durée et l'ampleur des dysfonctionnements lorsqu'ils surviennent. Pour permettre des interventions rapides et efficaces, il convient de détecter la survenance d'un incident au plus tôt et de localiser le plus précisément possible les zones du réseau concernées.

Les réseaux de transport et de répartition de l'énergie électrique correspondent à la partie amont de l'infrastructure électrique et acheminent l'énergie électrique sur de longues distances. De tels réseaux sont généralement équipés de systèmes de surveillance au moins en partie automatisés. Les réseaux de transport et de répartition comprennent notamment des capteurs aptes à transmettre à distance des données de surveillance de l'état du réseau. Les réseaux de distribution correspondent à la partie avale de l'infrastructure et acheminent l'énergie électrique sur de courtes distances mais jusque chaque noeud de consommation et depuis quelques noeuds producteurs. Les réseaux de distribution sont donc plus denses et nombreux que les réseaux de transport et de répartition. Par conséquent, équiper le réseau de distribution de systèmes de surveillance et en assurer la maintenance présenteraient un coût élevé. Les réseaux de distribution sont généralement dépourvus de tels systèmes de surveillance.

En pratique, un incident sur un réseau de distribution est généralement signalé au gestionnaire du réseau par un ou plusieurs utilisateurs constatant l'interruption de la fourniture d'énergie électrique. De tels signalements, généralement effectués par téléphone, sont peu précis et peu réactifs. Par exemple, lorsqu'une zone géographique entière est touchée, seuls quelques utilisateurs informent le gérant du réseau d'une anomalie. Il est alors impossible d'identifier avec certitude chacun des noeuds du réseau subissant une anomalie. Par conséquent, il est difficile de déduire la localisation précise d'une source du problème, telle qu'une rupture de câble. Les recherches des sources d'anomalies sont donc coûteuses et chronophages.

Depuis peu, les noeuds des réseaux de distribution peuvent être équipés de dispositifs communicants. Par exemple, des compteurs communicants, connus sous la référence commerciale « *Linky* » sont en cours de déploiement en France. De tels compteurs comprennent un module de communication apte à transmettre des données à distance de manière au moins en partie automatisée. De tels modules sont agencés pour transmettre des informations relatives à la consommation et/ou à la production, notamment dans un but de facturation. De tels modules ne sont pas prévus pour transmettre en temps réel des informations de coupures du réseau de distribution en amont. Les modules de communication des noeuds ne permettent donc pas, en l'état, de détecter des anomalies sur le réseau de distribution.

Par ailleurs, le document Jan Van De Vyver et al, "The need for a distributed algorithm for control of the electrical power infrastructure", in Proceedings of the International Symposium on Computational Intelligence for Measurement Systems and Applications 2003, CIMSA'03, 29-31 juillet 2003, pages 211-215 divulgue un module de détection d'anomalie sur un réseau de distribution électrique incluant une pluralité de noeuds, le document FR 3 036 906 A1 concerne une méthode d'obtention d'un trajet de communication entre un noeud et un concentrateur en utilisant des lignes de puissance.

L'invention exposée dans le jeu de revendication joint vient améliorer la situation.

Le procédé et le système de localisation de l'invention permettent de réduire le temps moyen de coupure d'alimentation électrique de noeuds d'un réseau de distribution électrique. Le procédé fournit une identification fiable des noeuds temporairement isolés du réseau, ce qui a pour effet de faciliter et d'accélérer la localisation d'une origine vraisemblable de l'anomalie. La surveillance du réseau peut être en grande partie automatisée et réalisée sensiblement en continu. En cas de dysfonctionnement, l'anomalie peut être détectée en temps réel et des mesures curatives adaptées à l'ampleur et à la localisation de l'anomalie peuvent être mises en oeuvre au plus tôt. Les désagréments causés par un dysfonctionnement sont de courte durée.

D'autres caractéristiques, détails et avantages de l'invention apparaîtront à la lecture de la description détaillée ci-après, et à l'analyse des dessins annexés, sur lesquels :
- la figure 1 représente schématiquement un ensemble de noeuds d'un réseau de distribution ;
- la figure 2 représente un diagramme fonctionnel d'un procédé selon l'invention ; et
- les figures 3 à 8 montrent une portion de réseau dans diverses situations.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

Dans un réseau 100 de distribution d'électricité sur lequel on souhaite appliquer le procédé décrit ci-après, on identifie habituellement des noeuds amonts et des noeuds avals. Par exemple, un noeud amont correspond à un transformateur disposé entre le réseau de transport moyenne tension (ou haute tension type A HTA) et le réseau de distribution basse tension (BT) en aval. Le réseau basse tension (BT), choisi en exemple, présente une structure arborescente. Le sommet de la structure arborescente correspond au noeud amont, matérialisé par un poste de transformation HTA/BT. Chaque noeud aval forme un point de branchement le long d'un des tronçons du réseau. Les noeuds avals correspondent sensiblement aux « Points De Livraison (PDL) » lorsqu'il s'agit de noeuds consommateurs. Les noeuds avals comprennent en outre des noeuds producteurs, ou fournisseurs, à partir desquels de l'énergie est fournie au réseau. Par exemple, des installations de type éolienne ou panneau photovoltaïque peuvent être reliées au réseau de distribution. Un noeud aval peut être un noeud consommateur et un noeud producteur. Chaque noeud aval forme une interface entre le réseau de distribution et un réseau électrique secondaire, généralement privé. En pratique, le noeud aval est matérialisé par un ensemble d'équipements, dont un compteur propre à comptabiliser la consommation et/ou la production électrique du réseau secondaire à des fins de facturation. Par abus de langage, les noeuds avals et leurs équipements peuvent être appelés compteurs.

Chacun des noeuds est équipé d'au moins un module de communication et d'une mémoire apte à stocker des données. Le module de communication, ou interface de communication, est apte à échanger des données avec un ensemble d'au moins un noeud voisin parmi la pluralité de noeuds et via le réseau 100. Ici, les modules de communication échangent des données entre eux par Courant Porteur en Ligne (CPL). Les modules de communication transmettent des données vers un module de communication particulier appelé module maître ou « concentrateur » commun. Chaque noeud peut transmettre des données au concentrateur directement ou par l'intermédiaire d'autres noeuds faisant fonction de relais de communication. Le concentrateur est, par exemple, situé au niveau d'un noeud amont tandis que les noeuds avals sont équipés de modules de communication non concentrateur. Chaque noeud est donc communicant. Dans la suite, transmettre des données d'un noeud à un autre signifie que les modules de communication respectifs équipant les noeuds mettent en oeuvre les transmissions de données.

Par exemple, les compteurs intelligents ou AMM pour « *Automated Meter Management* » sont aptes à échanger des données avec le concentrateur. Le concentrateur collecte les données de plusieurs AMM. Dans l'exemple décrit ici, le concentrateur transmet à son tour des informations à une unité de traitement distante et commune à plusieurs concentrateurs, par exemple via un réseau de téléphonie mobile. Ainsi, l'unité de traitement de données comprend au moins un processeur couplé de manière opérationnelle avec une mémoire pour mettre en oeuvre au moins en partie un procédé tel que défini dans les présentes. En variante, une partie au moins du traitement des données peut être mis en oeuvre par les concentrateurs et/ou localement par des équipements voisins des concentrateurs.

Parmi les AMM développés, certains comprennent des modules de communication fonctionnant par CPL. Ainsi, les données sont échangées par le réseau électrique lui-même sans qu'il soit nécessaire de prévoir un réseau de communication dédié entre le concentrateur et les autres modules de communication équipant les noeuds du réseau. Le réseau de communication utilise physiquement le réseau câblé électrique. Les modules de communication des noeuds, y compris le concentrateur, peuvent communiquer entre eux par CPL, ici exclusivement par CPL, tandis qu'un concentrateur communique en outre avec une unité de traitement par d'autres moyens, tels que les réseaux de téléphonie mobile.

Parmi les protocoles de communication CPL, certains se composent d'un terminal de coordination (ici le concentrateur) et de plusieurs terminaux de type appareil (ici les modules de communication des noeuds avals). L'ensemble des noeuds, ou terminaux, est parfois appelé « grappe CPL ». Les modules de communication des noeuds sont généralement alimentés en énergie par le réseau de distribution lui-même. Par conséquent, les noeuds cessent de fonctionner (et de transmettre des données) lorsque la fourniture d'énergie est interrompue.

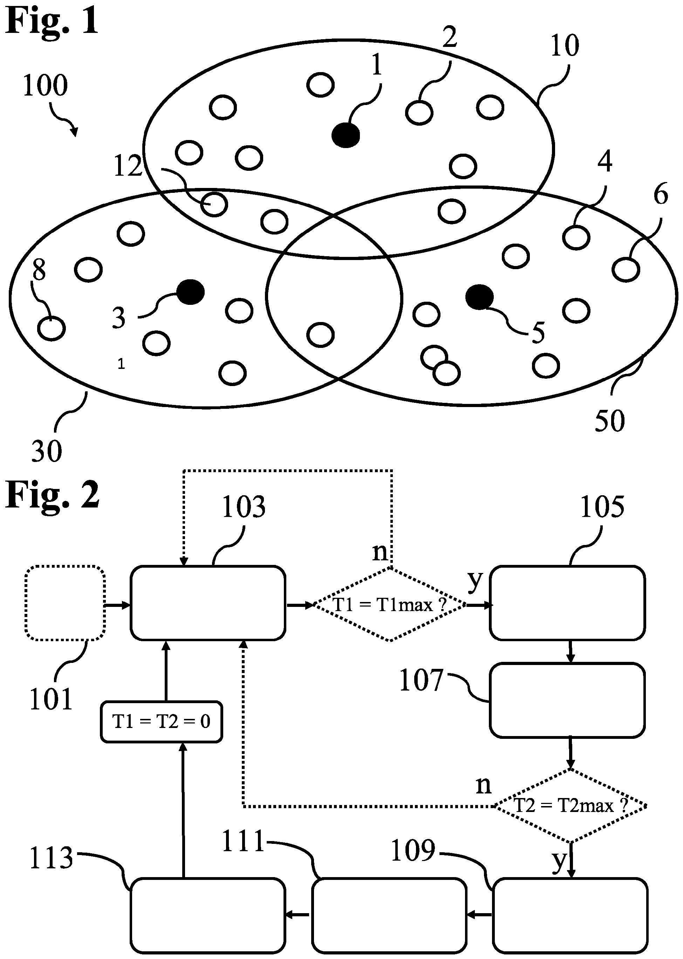

En figure 1, des noeuds d'un réseau de distribution d'électricité sont représentés par des petits cercles, portant ou non une référence numérique. Les positions relatives des noeuds sur la figure 1 ne correspondent pas nécessairement aux implantations géographiques réelles des noeuds. Les positions relatives des noeuds sur la figure 1 sont représentatives d'une métrique de routage des données sur le réseau électrique par CPL. Autrement dit, plus la distance entre deux petits ronds est importante sur la figure 1, plus la liaison électrique entre les deux noeuds correspondants sur le terrain est longue et/ou dégradée, et plus la probabilité de succès d'une communication directe par CPL entre les deux noeuds diminue. Ainsi, les grands ovales référencés 10, 30 et 50 sur la figure 1 représentent le « voisinage » des noeuds respectifs 1, 3 et 5. Le noeud référencé 1 correspond au noeud amont. Le noeud 1 comprend ici un module de communication formant concentrateur.

Ici et dans la suite, la notion de voisinage s'entend au sens des communications CPL et donc de distance câblée réelle. Dans ce contexte, la notion de voisinage ne saurait être confondue avec celle utilisée dans d'autres domaines tels que les réseaux de communications fonctionnant en courant faible et sous protocole IP, ou dans les communications sans fil de type téléphonie mobile. De manière simplifiée, il peut être considéré que seuls les noeuds disposés sur le réseau à une distance câblée mutuelle inférieure à une distance câblée seuil sont considérés comme des noeuds voisins l'un pour l'autre. En pratique, La faculté de deux noeuds à communiquer l'un avec l'autre par CPL dépend non seulement de la distance câblée mais aussi du bruit de fond, du bruit généré localement par des équipements perturbateurs, des impédances du réseau, etc.

Conformément à l'exemple représenté en figure 1 :
- le noeud 2 appartient au voisinage 10 du noeud 1 et n'appartient pas aux voisinages 30, 50 des noeuds respectifs 3 et 5 ;
- les noeuds 4 et 6 appartiennent au voisinage 50 du noeud 5 et n'appartiennent pas aux voisinages 10, 30 des noeuds respectifs 1 et 3 ;
- le noeud 8 appartient au voisinage 30 du noeud 3 et n'appartient pas aux voisinages 10, 50 des noeuds respectifs 1 et 5 ;
- le noeud 12 appartient à la fois aux voisinages 10 et 30 des noeuds respectifs 1 et 3 et n' appartient pas au voisinage 50 du noeud respectif 5 ; et
- les noeuds 1, 3 et 5 n'appartiennent pas aux voisinages les uns des autres.

Dans les exemples décrits ici, les noeuds communiquent par CPL en respectant la norme connue sous la référence « CPL G3 ». La norme est définie notamment dans le document référencé « ITU-T G.9903, version approuvée le 22 février 2014, éditée par l'International Telecommunication Union (ITU) et portant l'identifiant 11.1002/1000/12088 », que le lecteur est invité à consulter. Ainsi, la mise en oeuvre du procédé est compatible avec les protocoles CPL existants. À la date de rédaction des présentes, les dernières versions des compteurs *« Linky* » déployés en France par la demanderesse sont compatibles avec la norme CPL G3. En variante, le procédé peut être mis en oeuvre avec des noeuds équipés de modules de communication fonctionnant par CPL selon d'autres normes, par exemple la norme plus ancienne CPL G1, et probablement avec les évolutions futures du standard ITU-T G9903. Par exemple, des modules de communication d'anciennes générations peuvent être équipés de matériels et/ou logiciels complémentaires afin de les rendre compatibles avec le procédé.

Conformément à la norme, chaque noeud stocke en mémoire et actualise un ensemble de données parmi lesquelles une « table des voisins » ou « table de voisinage ». Il existe donc une table des voisins par noeud. Bien que le terme « voisin » soit employé au pluriel, certains au moins des noeuds peuvent comprendre un unique voisin.

La table des voisins d'un noeud 1 prend la forme d'un ensemble de données contenant des informations relatives à l'état du voisinage 10 du noeud 1. La table des voisins comprend au moins une liste d'identifiants correspondant à chacun des noeuds voisins 2, 12. L'identifiant prend ici la forme d'une adresse courte, appelée « *Short_Address* » selon la norme CPL G3. L'identifiant est unique pour chaque noeud d'un réseau.

Dans chaque table de voisins, chacun des identifiants est associé à au moins une donnée d'état. Dans des modes de réalisation, la donnée d'état prend la forme d'une valeur booléenne, par exemple « OK » ou « KO ». La donnée d'état peut donc prendre la forme d'un paramètre en tant que tel. En variante, il peut être considéré que la simple présence d'un identifiant de noeud dans la table équivaut à une donnée d'état, par exemple « OK », tandis que l'absence d'un identifiant de noeud dans la table équivaut à une autre donnée d'état, par exemple « KO ».

Dans les exemples décrits ci-après, les données d'état comprennent une valeur représentative d'une durée d'interruption de communication. Chaque donnée d'état prend la forme d'un paramètre dont la valeur est un entier compris entre 0 et 255. La valeur peut être interprétée comme représentative d'une durée de validité du statut fonctionnel (« OK ») du noeud voisin dont l'identifiant est associé. Cette valeur est appelée « *Neighbour_Valid_Time* » selon la norme CPL G3. Le paramètre, ou attribut, prend la forme d'un compte à rebours initialisé à une valeur maximale (ici 255 selon la norme CPL G3). Chaque fois qu'une activité du noeud voisin 2, 12 correspondant à l'identifiant est détectée par le noeud 1 auquel appartient la table des voisins, la variable d'état est réinitialisée, ici à sa valeur 255. Puis, la valeur est décrémentée d'une unité à intervalle de temps régulier, par exemple chaque minute, jusqu'à atteindre zéro et tant qu'aucune activité de la part du noeud voisin 2, 12 correspondant n'est détectée. Lorsque la valeur zéro est atteinte, il peut être considéré que la validité du statut fonctionnel (« OK ») du noeud voisin 2, 12 associé a expiré et que le noeud associé 2, 12 est donc non fonctionnel (« KO »). Par exemple, lorsque la valeur zéro est atteinte, l'identifiant associé est supprimé de la table.

Une table des voisins peut être représentée par les tableaux I, II et III suivants, correspondant respectivement aux voisinages 10, 30 et 50. Chaque ligne du tableau correspond ici à un des noeuds voisin. Sur les tableaux suivants, seules quelques lignes sont représentées. En variantes, des colonnes supplémentaires contenant des informations supplémentaires sur chacun des noeuds voisins sont prévues. Par exemple, les données d'états sont en outre associées à des données de date. Par exemple, une date peut renseigner sur la date de la dernière activité constatée d'un noeud voisin par un noeud.

**Tableau I (voisinage 10 du noeud 1) :**

| Short_Address | Neighbour_Valid_Time |
|---|---|
| 0002 | 255 |
| 0012 | 255 |
| ... | ... |

**Tableau II (voisinage 30 du noeud 3) :**

| Short_Address | Neighbour_Valid_Time |
|---|---|
| 0008 | 255 |
| 0012 | 255 |
| ... | ... |

**Tableau III (voisinage 50 du noeud 5) :**

| Short_Address | Neighbour_Valid_Time |
|---|---|
| 0004 | 255 |
| 0006 | 200 |
| ... | ... |

Lorsque la donnée d'état prend la forme d'une valeur booléenne, par exemple « OK » ou « KO », plutôt que celle d'une durée de validité, chaque fois qu'une activité du noeud voisin correspondant à l'identifiant est détectée par le noeud auquel correspond la table des voisins, la variable d'état est réinitialisée, par exemple à la valeur « OK ». Puis, la valeur est changée en « KO », ou bien l'identifiant associé est supprimé de la table après écoulement d'une durée prédéfinie sans activité détectée, par exemple après 255 minutes.

Les activités d'un noeud voisin détectées peuvent comprendre des transmissions de données de la part du noeud voisin. Par exemple, lorsque le noeud 6 appartenant au voisinage 50 envoie des données à destination du noeud amont 1, le noeud 5 détecte l'envoi des données et interprète cet envoi comme une activité du noeud voisin 6. Une telle détection peut résulter du relai des données en provenance d'un noeud tiers à destination d'un autre noeud tiers par le noeud 6.

Les noeuds peuvent être agencés pour initier une transmission de données à des intervalles réguliers, de préférence à des intervalles inférieurs à la durée de validité sélectionnée pour la variable d'état. Dans l'exemple décrit ci-avant d'une durée de validité de 255 minutes, les noeuds peuvent être agencés, par exemple, pour transmettre des données chaque heure. Les données transmises peuvent comprendre des informations, par exemple destinées à la facturation, ou bien consister en un bref signal de bon fonctionnement de type *« ping ».*

En variante, un message destiné à être répété par tous les noeuds du réseau peut être envoyé sur le réseau, par exemple depuis le noeud amont 1. Un tel message peut par exemple être transmis par diffusion large (« *broadcasting* »). Ainsi, tout noeud du réseau recevant un tel message le relaie, ce qui constitue une activité détectable par les noeuds voisins. Dans ce cas, il n'est pas nécessaire que les noeuds soient agencés pour initier eux-mêmes une transmission de données à des intervalles réguliers ou à des intervalles inférieurs à la durée de validité sélectionnée pour la variable d'état. Par exemple, les noeuds peuvent être configurés pour initier une transmission de données seulement une fois toutes les 24 heures environ, et pour relayer une trame de type broadcast à chaque réception de ladite trame. L'envoi d'une trame de type broadcast peut être prévue à intervalles réguliers (inférieurs à la durée de validité de la variable d'état). Un tel envoi peut être prévu, en supplément ou en remplacement de l'envoi régulier, préalablement à la collecte des tables de voisinage. L'envoi d'une trame de type broadcast permet de mettre à jour, ou réinitialiser, la variable d'état de chaque noeud voisin opérationnel et connecté au réseau dans chaque table de voisinage des noeuds opérationnels et connectés au réseau.

Dans le contexte de noeuds reliés au réseau d'alimentation électrique, les équipements associés peuvent aisément être alimentés en énergie par ledit réseau (par opposition à un fonctionnement sur batterie). Dans ces cas, les transmissions de données sont peu coûteuses en énergie et peuvent donc être mises en oeuvre de manière régulière et/ou à volonté. Par exemple, une trame de type broadcast peut être transmise sur le réseau, par une action humaine ou de manière automatisée, chaque fois que l'on souhaite vérifier le bon fonctionnement des noeuds du réseau.

Selon le protocole défini dans la norme CPL G3, la propagation de message par *« broadcasting* » est prévue pour créer ou réparer des routes dans le réseau CPL. De telles routes permettent de transporter des messages CPL d'équipement en équipement entre une source et une destination sur le réseau de distribution électrique. Les trames de type broadcast peuvent être déclenchées volontairement depuis le noeud amont (ou concentrateur), ou se déclencher d'elles même, par exemple pour réparer une route existante suite à un échec de communication le long de celle-ci.

Dans une situation dans laquelle tous les noeuds du réseau sont opérationnels, et après envoie d'une trame de type broadcast, toutes les tables de voisinage comprennent l'ensemble des noeuds voisins respectifs et toutes les variables d'état ont une valeur correspondant à un bon fonctionnement, par exemple « OK » ou une durée de validité « *Neighbour_Valid_Time* » égale à 255.

Les tableaux I, II et III ci-avant, correspondent à une situation dans laquelle chaque noeud du réseau électrique est fonctionnel à l'exception du noeud 6 qui a récemment été mis hors tension (ou déconnecté du réseau). Le noeud 6, ayant pour identifiant « 0006 », est situé dans le voisinage 50 du noeud 5. Par conséquent, la variable d'état « *Neighbour_Valid_Time* » associée à l'identifiant « 0006 » de la table des voisins du noeud 5 (tableau III ci-avant) n'a pas été récemment initialisée à 255 : elle présente la valeur « 200 ». Cela signifie que la dernière activité du noeud 6 détectée par le noeud 5 date de 55 minutes.

En effet, le noeud 6 étant hors tension, il n'est plus capable de communiquer en CPL, et donc de participer à la répétition des messages de type broadcast. La durée de validité qui lui est associée, ou de manière générale la variable d'état qui lui est associée, dans les tables de voisinage du réseau n'est donc pas rafraîchie. Dans l'exemple décrit, seule la table de voisinage correspondant au voisinage 50 du noeud 5 compte le noeud 6 parmi ses noeuds voisins (tableau III). La durée de validité *« Neighbour_Valid Time* » associée au noeud 6 (dont l'identifiant est « 0006 ») dans une autre table de voisinage, par exemple celle du noeud 4, serait elle-aussi inférieure à 255 si elle avait été représentée.

Il est maintenant fait référence à la figure 2 représentant le déroulement d'un mode de réalisation du procédé. Dans l'exemple décrit ici, le procédé comprend une opération préliminaire optionnelle 101. L'opération 101 est, par exemple, mise en oeuvre par le concentrateur ou des équipements qui lui sont associés. Un signal d'initialisation est envoyé sur le réseau par CPL. Le signal est agencé de manière à générer une activité de chacun des noeuds du réseau, activité apte à être détectée par les noeuds voisins. L'opération 101 comprend, par exemple, l'envoi d'une trame de type broadcast sur le réseau 100. Chacun des noeuds est agencé pour relayer par CPL la trame de noeuds en noeuds.

Le procédé comprend une opération 103. L'opération 103 est mise en oeuvre par chacun des noeuds ou des équipements qui leurs sont respectivement associés. L'opération 103 comprend l'enregistrement dans la mémoire de chaque noeud d'un jeu de données d'état. Chaque donnée d'état est associée à un noeud voisin du noeud auquel appartient la mémoire, par exemple au moyen d'un identifiant de chaque noeud voisin. Le jeu de données d'état prend, par exemple la forme d'une table de voisinage telle que décrite ci-avant. Les données d'état sont fonction de la détection ou de l'absence de détection par le noeud d'une activité du noeud voisin. Comme décrit ci-avant, les données d'état peuvent prendre la forme d'une table de voisins conforme à la norme CPL G3.

Le procédé comprend en outre une opération 105. L'opération 105 est, par exemple, mise en oeuvre par le concentrateur ou des équipements qui lui sont associés. L'opération 105 comprend la collecte de jeux de données d'état mémorisés en une pluralité de noeuds. Autrement dit, les données d'état mémorisées séparément par chaque noeud du réseau sont au moins en partie centralisées. Par exemple, les données d'état sont transmises à un concentrateur commun à l'ensemble des noeuds du réseau. Le concentrateur peut être situé au niveau d'un noeud amont. Les données d'état sont transmises, ici par CPL, jusqu'au concentrateur. Les données sont relayées jusqu'au concentrateur par les noeuds du réseau, notamment lorsqu'un noeud ne peut pas communiquer directement avec le concentrateur par CPL. Par exemple, lorsque les conditions de propagation du canal ne permettent pas qu'un signal CPL puisse être transmis directement dans de bonnes conditions, alors les noeuds intermédiaires font office de relais. Un tel fonctionnement est, par exemple, prévu par la norme CPL G3.

Le procédé comprend en outre une opération 107. L'opération 107 est, par exemple, mise en oeuvre par le concentrateur ou des équipements qui lui sont associés, par exemple un module de détection d'anomalie incluant au moins un processeur associé au concentrateur. L'opération 107 comprend le croisement (ou recoupement) des données d'état collectées auprès de la pluralité de noeuds.

Les données d'état associées à chaque noeud et obtenues auprès de plusieurs noeuds différents sont rassemblées et/ou comparées les unes aux autres. En théorie, les données relatives à un noeud devraient être identiques quel que soit la table de voisins dont elles sont tirées. En pratique, un tel croisement permet de détecter des erreurs ou incohérences.

Le croisement des données peut inclure un tri parmi les informations tirées des données collectées. Ainsi, la fiabilité des données d'état est améliorée *a posteriori.* Par exemple, lorsque les données d'états associées à un même noeud et obtenues auprès de plusieurs noeuds différents les uns des autres sont identiques ou similaires, il peut être considéré que les données d'état sont fiables. Cela est applicable, que les données indiquent que le noeud est opérationnel ou que les données indiquent que le noeud est non opérationnel. Dans ces cas, une donnée d'état fiabilisée (après croisement des données) est établie. Lorsque des divergences apparaissent entre les données d'états associées à un même noeud et obtenues auprès de plusieurs noeuds différents, alors seules certaines de ces données peuvent être retenues. Par exemple, il peut être considéré qu'un unique jeu de données indiquant qu'un noeud est opérationnel suffit à considérer ledit noeud comme opérationnel même si d'autres données contiennent des informations contradictoires. Une donnée d'état fiabilisée est alors établie.

Le procédé comprend en outre une opération 109. L'opération 109 comprend l'identification des noeuds pour lesquels les données d'état qui lui sont attribuées, ou bien l'évolution desdites données d'état, indiquent une absence d'activité. L'opération 109 est, par exemple, mise en oeuvre par le concentrateur ou des équipements qui lui sont associés, par exemple un module de détection d'anomalie incluant au moins un processeur associé au concentrateur. En fonction des données d'état collectées, optionnellement fiabilisées, les noeuds opérationnels sont distingués des noeuds non opérationnels. Les noeuds non opérationnels sont identifiés.

Les données d'état collectées, optionnellement fiabilisées, sont à leur tour mémorisées, par exemple dans une mémoire associée au concentrateur. Les données d'état collectées prennent, par exemple, la forme d'une matrice de voisinage.

Le procédé comprend en outre une opération 111. L'opération 111 est, par exemple, mise en oeuvre par le concentrateur ou des équipements qui lui sont associés, par exemple un module de détection d'anomalie incluant au moins un processeur associé au concentrateur. L'opération 111 comprend la déduction d'une localisation vraisemblable d'une anomalie sur le réseau 100 en fonction des noeuds identifiés à l'opération 109 et d'une cartographie du réseau. En associant les noeuds non opérationnels identifiés à leur position respective sur le réseau et/ou à leur position géographique, il peut être défini une zone probable de la source d'une anomalie sur le réseau.

La déduction peut être mise en oeuvre en fonction des noeuds voisins identifiés pour lesquels l'absence de communication est d'une durée supérieure à une durée seuil. Par exemple, lorsque les données d'états sont représentatives d'une durée, une comparaison avec une durée seuil peut constituer un critère pour déduire le caractère opérationnel ou non opérationnel de chaque noeud.

Dans une opération 113, un signal d'alerte incluant des données de localisation de l'anomalie peut être généré. L'opération 113 est, par exemple, mise en oeuvre par le concentrateur ou des équipements qui lui sont associés, par exemple un module de détection d'anomalie incluant au moins un processeur, associé au concentrateur. Ainsi, à réception du signal, il est possible non seulement d'être informé de la survenance d'une anomalie mais aussi de la zone à traiter sur le réseau. Cela participe à la rapidité de réparation du réseau. Cela permet, en outre, de définir des priorités d'intervention en cas de multiples anomalies. Par exemple, il peut être décidé de traiter en priorité les anomalies pour lesquelles le nombre de noeuds impactés (et donc *a priori* le nombre d'utilisateurs) est le plus important.

Dans des modes de réalisation, les opérations sont mises en oeuvre dans l'ordre de leur description ci-avant. Dans des modes de réalisation, le procédé comprend plusieurs itérations de la série d'opérations définies ci-avant. Par exemple, la mise en oeuvre d'itérations successives des opérations permet une surveillance sensiblement en continu du réseau. Dans des modes de réalisation, les opérations 101 à 113 sont mises en oeuvre tour à tour (une fois chaque opération) en formant une série.

Dans des variantes, une même opération est mise en oeuvre plusieurs fois successivement au cours d'une même série. Par exemple, l'opération 103 d'enregistrement des données d'état de chaque noeud est mise en oeuvre elle-même de manière récursive au cours d'une itération des opérations 103 à 113. Après plusieurs itérations de l'opération 103 au cours d'une même série, l'opération 105 de collecte (ou centralisation) est mise en oeuvre. Cette réitération optionnelle de l'opération 103 est représentée en figure 2 par la boucle « T1 = T1max ? ». Autrement dit, chaque noeud maintient à jour sensiblement en continu les données d'état relatives aux noeuds voisins. À une fréquence moins élevée, les données d'états mises à jour sont collectées (centralisées) sur le concentrateur par l'opération 105.

De même, une série d'opération 103-105-opitionnellement 107 peut être mise en oeuvre de manière récursive de manière à tenir à jour la matrice de voisinage. Cette réitération optionnelle de la succession des opérations est représentée en figure 2 par la boucle « T2 = T2max ? ». À une fréquence moins élevée, les opérations 109 et 111 sont mises en oeuvre.

Lors de la mise en oeuvre de manière itérative des opérations précitées, la première itération peut être vue comme la constitution d'une matrice de voisinage tandis que les itérations suivantes peuvent être vues comme une mise à jour et/ou un enrichissement de la matrice de voisinage.

L'opération 109 d'identification des noeuds non opérationnels peut inclure la mise en oeuvre d'un algorithme, par exemple par le module de détection d'anomalie, visant à détecter le non rafraîchissement dans la matrice de voisinage de données relatives à certains noeuds. En effet, lorsque les données d'état d'un noeud sont supprimées des tables des voisins parce qu'aucune activité n'est détectée, il peut être nécessaire d'identifier de tels noeuds par l'absence de mise à jour desdites données dans la matrice de voisinage.

L'opération 109 d'identification des noeuds non opérationnels peut inclure des comparaisons avec un historique. Ainsi, des faux positifs peuvent être évités : un noeud ayant habituellement des difficultés de communication peut apparaître comme défaillant alors même que l'alimentation électrique au niveau du noeud reste opérationnelle. Mesurer un écart avec l'historique permet de déterminer un écart à la normalité. Un faible écart à la normalité peut traduire une situation de mauvaise communication sans pour autant que le déclenchement d'une alerte ne soit pertinent.

L'opération 105 de collecte peut être mise en oeuvre automatiquement par une routine informatique, par exemple pour une surveillance en continu. L'opération 105 peut, en alternative ou en complément d'une mise en oeuvre automatique, être déclenchée suite à une suspicion d'anomalie. Un tel déclenchement peut être lui-même automatisé en fonction de paramètres prédéfinis ou être manuel.

La mise en oeuvre d'un tel procédé est compatible avec certains au moins des équipements en cours de déploiement par la demanderesse sur le territoire français (compteurs « *Linky* »). Ainsi, la mise en oeuvre du procédé ne nécessite pas l'installation de matériel complémentaire. Dans la plupart des cas, une mise à jour logicielle des composants informatiques équipant les noeuds est suffisante pour les rendre aptes à la mise en oeuvre du procédé. Une telle mise à jour peut être réalisée à distance sans nécessiter le déplacement d'un opérateur.

La demanderesse a mené des essais de mise en oeuvre du procédé. L'installation comprenait les éléments suivants :
- un noeud amont formant concentrateur comprenant un module de communication respectant la norme CPL G3 et installé dans un poste de transformation Haute tension-Basse tension (HTA/BT) ; et
- cent modules de communication respectant la norme CPL G3 répartis sur 20 panneaux de 5 équipements.

Les modules ont été répartis sur deux départs distincts du transformateur, chacun des départs incluant une ligne d'environ 600 mètres. Un bruit blanc de 5 volts a été injecté en quatre points du réseau afin de limiter artificiellement la propagation de signaux CPL et de limiter le rayon de voisinage de chaque module de sorte que du routage soit nécessaire (communications indirectes). En pratique, il a été constaté 2 à 3 sauts au maximum parmi les routes.

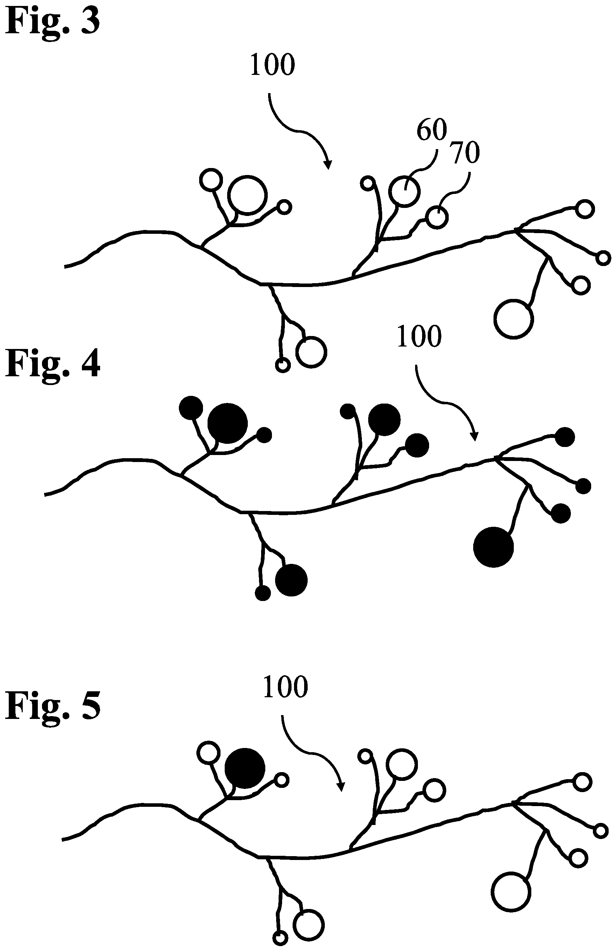

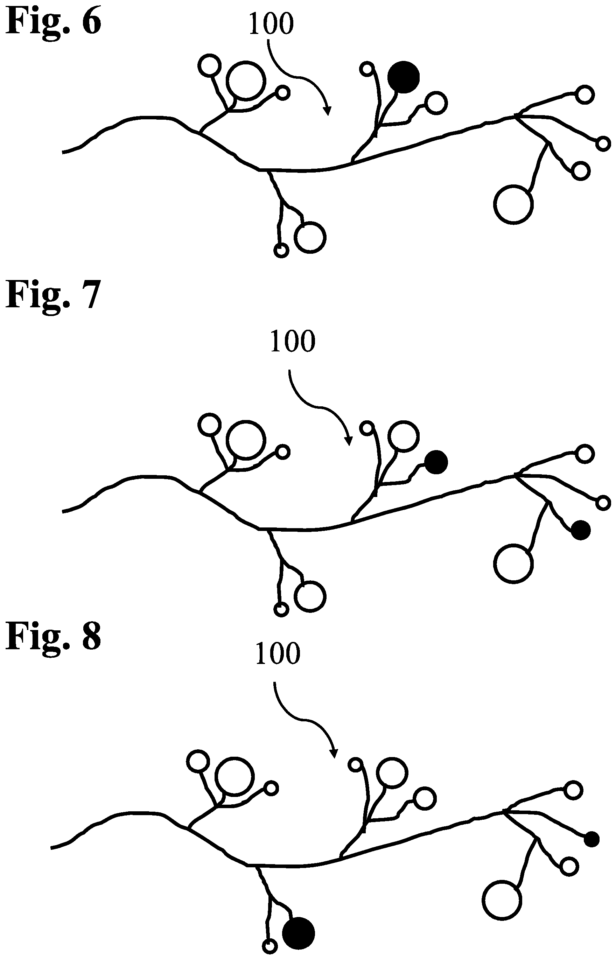

Pour les essais, une même structure du réseau a été mise en oeuvre. Plusieurs situations ont été testées durant lesquelles différents noeuds ont été volontairement mis hors tension. Les figures 3 à 8 représentent chacune une situation testée. Sur les figures les cercles vides représentent des groupes 60, 70 de noeuds fonctionnels tandis que les cercles pleins représentent des groupes de noeuds éteints. La taille des cercles est représentative du nombre de noeuds constituant chaque groupe, ici entre 1 et 30 noeuds.

Les résultats des essais sont regroupés dans le tableau IV ci-après.

| **Cas** | **Figure** | **Composition des groupes de nœuds éteints** | **Temps de détection de la coupure** | **Identification des compteurs éteints** |
|---|---|---|---|---|
| A | 3 | Aucun | 1 minute | Complète et sans faux positif |
| B | 4 | Tous (100 noeuds au total) | 2 minutes et 20 secondes | Complète et sans faux positif |
| C | 5 | 1 groupe de 30 | 2 minutes et 30 secondes | Complète et sans faux positif |
| D | 6 | 1 groupe de 20 | 2 minutes | Complète et sans faux positif |
| E | 7 | 1 groupe de 20 et un groupe de 10 | 3 minutes et 20 secondes | Complète et sans faux positif |
| F | 8 | 1 groupe de 20 et un groupe de 1 | 2 minutes et 10 secondes | Complète et sans faux positif |

Bien que cela n'apparaisse pas dans le tableau IV, chacun des noeuds éteints est identifié. Ainsi, des cartographies du réseau 100 peuvent être construites, sur lesquelles sont distingués les noeuds non fonctionnels des noeuds fonctionnels, à l'image des figures 3 à 8. Les précisions de localisation permettent d'adapter en conséquence les mesures curatives à mener et donc de réduire encore les durées d'interruption de la fourniture d'énergie pour les noeuds impactés.

Dans ce qui précède, le procédé est appliqué sur l'ensemble des noeuds d'un réseau de distribution d'énergie électrique. Dans des variantes, le procédé peut être appliqué en parallèle sur plusieurs groupes de noeuds d'un même réseau. Les groupes peuvent être complètement distincts ou bien comprendre des noeuds communs. La composition de chaque ensemble peut être sélectionnée en fonction des positions des noeuds sur le réseau de sorte qu'un signal d'alerte est associé à une zone prédéfinie du réseau. Ainsi, lorsqu'une alerte est générée pour un groupe, le signal peut être associé à une zone du réseau.

Dans ce qui précède, la mise en oeuvre du procédé est décrite comme une succession d'opérations, quel que soit l'élément mettant en oeuvre les diverses opérations. En fonction des acteurs intervenant sur le réseau, différentes parties de la succession d'opérations sont mises en oeuvre. Autrement dit, la succession des opérations peut aussi être vue comme une combinaison de procédés complémentaires les uns des autres.

L'invention peut aussi être vue comme un module de détection agencé pour mettre en oeuvre certaines seulement des opérations, par exemple celles mises en oeuvre par le noeud amont, ou concentrateur. L'invention peut aussi être vue comme un programme informatique comportant des instructions pour la mise en oeuvre du procédé lorsque ce programme est exécuté par un processeur, par exemple un processeur équipant le module de détection d'anomalie. L'invention peut aussi être vue comme un support d'enregistrement non transitoire lisible par un ordinateur sur lequel est enregistré un tel programme.

L'invention ne se limite pas aux exemples de procédé et de modules décrits ci-avant, seulement à titre d'exemple, mais elle englobe toutes les variantes que pourra envisager l'homme de l'art dans le cadre de la protection recherchée.

On notera que les solutions proposées ici sont particulièrement bien adaptées aux installations physiques existantes. Cela dispense de nombreuses opérations coûteuses de changement du matériel. Un module de communication par CPL conformes à la norme G3 est particulièrement bien adapté. En France par exemple, une grande partie des équipements déjà déployés sur le terrain sont conformes à la norme G3. Pour mettre en oeuvre les solutions proposées ici, il est donc superflu de déployer des modules CPL dont les propriétés seraient supérieures à (meilleures que) celles de la norme G3, notamment en termes de débit, de fiabilité et de capacité de traitement.

En outre, les procédés et variantes définis dans les présentes peuvent être mis en oeuvre localement, à l'échelle d'un quartier, typiquement au niveau d'un transformateur disposé entre le réseau de transport moyenne tension (ou haute tension type A HTA) et le réseau de distribution basse tension (BT) en aval. Le module de détection d'anomalie mentionné dans les présentes peut former équipement d'un tel transformateur. En effet, des ressources informatiques modestes suffisent à la mise en oeuvre du procédé. Il est donc superflu de déporter la mise en oeuvre du procédé sur des équipements informatiques distants et puissants (utilisation du « *cloud* » par exemple). Centraliser la mise en oeuvre du procédé à l'échelle d'un réseau de distribution électrique national, tel que le réseau français, est superflu.

On comprend du contexte qui précède que l'une des anomalies que l'on souhaite localiser, optionnellement l'unique anomalie, est l'interruption d'alimentation électrique.

## Revendications

1. Procédé de localisation d'anomalie sur un réseau (100) de distribution électrique incluant une pluralité de noeuds (1, 2, 3, 4, 5, 6, 8, 12) reliés directement ou indirectement à un noeud concentrateur, chacun des noeuds de la pluralité de noeuds étant équipé :
- d'un module de communication par Courant Porteur en Ligne apte à échanger des données avec ledit noeud concentrateur et avec un ou plusieurs noeuds voisins parmi la pluralité de noeuds et via le réseau (100), et
- d'une mémoire apte à stocker des données;
le noeud concentrateur comprenant:
- un module de communication par Courant porteur en Ligne configuré pour communiquer avec lesdits noeuds, et
- un module de détection d'anomalie,
le noeud concentrateur étant configuré pour transmettre des informations à une unité de traitement distante et commune à plusieurs noeuds concentrateurs, par exemple via un réseau de téléphonie mobile;
le procédé comprenant :
a) enregistrer dans la mémoire des noeuds un ou plusieurs jeux de données d'état, pour lequel chaque donnée d'état est associée à un noeud voisin du noeud auquel appartient la mémoire, les données d'état étant fonction de la détection ou de l'absence de détection par ledit noeud d'une activité dudit noeud voisin,
b) collecter (105) dans le noeud concentrateur des jeux de données d'état mémorisés en une pluralité de noeuds, chacun des jeu étant mémorisé en un noeud respectif,
c) par comparaison et croisement des données d'état collectées par le noeud concentrateur, identifier (109) au niveau du noeud concentrateur des noeuds (6) pour lesquels les données d'état associées ou l'évolution des données d'état associées indiquent une absence d'activité, déduire (111) dans le noeud concentrateur ou dans ladite unité de traitement distante et commune à plusieurs noeuds concentrateurs une localisation vraisemblable d'une anomalie sur le réseau à partir des noeuds identifiés et d'une cartographie dudit réseau.

2. Procédé selon la revendication 1, dans lequel chacune des données d'état est en outre associée à une donnée de date.

3. Procédé selon l'une des revendications précédentes, dans lequel les données d'état comprennent une valeur représentative d'une durée d'interruption de communication.

4. Procédé selon l'une des revendications précédentes, dans lequel la déduction (111) est mise en oeuvre en fonction des noeuds voisins identifiés pour lesquels l'absence de communication est d'une durée supérieure à une durée seuil.

5. Procédé selon l'une des revendications précédentes, dans lequel seuls les noeuds disposés sur le réseau dans une zone permettant la communication directe par CPL sont considérés comme des noeuds voisins l'un pour l'autre.

6. Procédé selon l'une des revendications précédentes, dans lequel une succession des opérations est mise en oeuvre de manière réitérée au cours du temps, de sorte que la détection d'anomalie est mise en oeuvre sensiblement en temps réel.

7. Procédé selon l'une des revendications précédentes, comprenant en outre une étape préalable d'envoi (101) sur le réseau d'une trame à diffusion large à destination de l'ensemble des noeuds.

8. Système de localisation d'anomalies sur un réseau (100) de distribution électrique adapté à la mise en oeuvre du procédé de l'une quelconque des revendications précédentes, le système comportant une pluralité de noeuds (1, 2, 3, 4, 5, 6, 8, 12) munis :
- de moyens de mémorisation adaptés à enregistrer dans une mémoire des noeuds un ou plusieurs jeux de données d'état, pour lequel chaque donnée d'état est associée à un noeud voisin du noeud auquel appartient la mémoire, les données d'état étant fonction de la détection ou de l'absence de détection par ledit noeud d'une activité dudit noeud voisin, et
- d'un module de communication par Courant porteur en Ligne reliant lesdits noeuds entre eux et avec un noeud concentrateur auquel sont reliés directement ou indirectement lesdits noeuds,
ledit noeud concentrateur étant :
- équipé d'un module de communication par Courant porteur en Ligne pour communiquer avec lesdits noeuds,
- configuré pour transmettre des informations à une unité de traitement distante et commune à plusieurs noeuds concentrateurs, par exemple via un réseau de téléphonie mobile, et,
- muni d'un module de détection d'anomalie adapté à :
a) collecter (105) dans le noeud concentrateur des jeux de données d'état mémorisés en une pluralité de noeuds,
b) par comparaison et croisement des données d'état collectées, identifier (109) des noeuds (6) pour lesquels les données d'état associées ou l'évolution des données d'état associées indiquent une absence d'activité, déduire (111) une localisation vraisemblable d'une anomalie sur le réseau à partir des noeuds identifiés et d'une cartographie dudit réseau.

9. Noeud concentrateur pour un système de localisation d'anomalies sur un réseau (100) de distribution électrique selon la revendication 8, le noeud concentrateur comprenant:
- un module de communication par Courant porteur en Ligne configuré pour communiquer avec une pluralité de noeuds du réseau de distribution électrique, et
- un module de détection d'anomalie,
le noeud concentrateur étant configuré pour transmettre des informations à une unité de traitement distante et commune à plusieurs noeuds concentrateurs, par exemple via un réseau de téléphonie mobile; et
le module de détection d'anomalie comportant au moins un processeur agencé pour :
a) collecter (105) des jeux de données d'état mémorisés en la pluralité de noeuds, chacun des jeu étant mémorisé en un noeud respectif,
b) par croisement et comparaison des données d'état collectées, identifier (109) des noeuds (6) pour lesquels les données d'état associées ou l'évolution des données d'état associées indiquent une absence d'activité, déduire (111) des noeuds identifiés et d'une cartographie du réseau une localisation vraisemblable d'une anomalie sur le réseau.

10. Programme d'ordinateur comprenant des instructions qui conduisent le système selon la revendication 8 à exécuter les étapes du procédé selon l'une quelconque des revendication 1 à 7.

11. Support lisible par ordinateur, sur lequel est enregistré le programme d'ordinateur selon la revendication 10.

## Patentansprüche

1. Verfahren zur Lokalisierung einer Anomalie in einem elektrischen Verteilungsnetz (100), das eine Mehrzahl von Knoten (1, 2, 3, 4, 5, 6, 8, 12) umfasst, die direkt oder indirekt mit einem Konzentratorknoten verbunden sind, wobei jeder der Knoten der Mehrzahl von Knoten ausgestattet ist mit:
- einem Powerline-Kommunikationsmodul, das in der Lage ist, Daten mit dem Konzentratorknoten und mit einem oder mehreren benachbarten Knoten der Mehrzahl von Knoten und über das Netz (100) auszutauschen, und
- einem Speicher, der in der Lage ist, Daten zu speichern;
wobei der Konzentratorknoten umfasst:
- ein Powerline-Kommunikationsmodul, das dazu ausgebildet ist, mit den Knoten zu kommunizieren, und
- ein Modul zur Erfassung einer Anomalie,
wobei der Konzentratorknoten dazu ausgebildet ist, Informationen an eine entfernte und mehreren Konzentratorknoten gemeinsame Verarbeitungseinheit zu übertragen, z. B. über ein Mobiltelefonnetz;
wobei das Verfahren umfasst:
a) Speichern eines oder mehrerer Sätze von Statusdaten in dem Speicher der Knoten, wobei jede Statusdateneinheit einem benachbarten Knoten des Knotens zugeordnet ist, zu dem der Speicher gehört, wobei die Statusdaten von der Erfassung oder Nicht-Erfassung einer Aktivität des benachbarten Knotens durch den Knoten abhängig sind,
b) Sammeln (105) von Sätzen von Statusdaten, die in einer Mehrzahl von Knoten gespeichert sind, in dem Konzentratorknoten, wobei jeder der Sätze in einem entsprechenden Knoten gespeichert ist,
c) durch Vergleich und Kreuzung der vom Konzentratorknoten gesammelten Statusdaten, Identifizieren (109) von Knoten (6) am Konzentratorknoten, bei denen die zugeordneten Statusdaten oder die Entwicklung der zugeordneten Statusdaten auf eine fehlende Aktivität hindeuten, Ableiten (111) im Konzentratorknoten oder in der entfernten und mehreren Konzentratorknoten gemeinsamen Verarbeitungseinheit einer wahrscheinlichen Lokalisierung einer Anomalie im Netz anhand der identifizierten Knoten und einer Kartografie des Netzes.

2. Verfahren nach Anspruch 1, wobei jedes der Statusdaten ferner einer Datumsangabe zugeordnet wird.

3. Verfahren nach einem der vorhergehenden Ansprüche, wobei die Statusdaten einen Wert umfassen, der für eine Dauer der Kommunikationsunterbrechung steht.

4. Verfahren nach einem der vorhergehenden Ansprüche, wobei die Ableitung (111) in Abhängigkeit von den identifizierten benachbarten Knoten durchgeführt wird, für die die Dauer der Kommunikationsunterbrechung länger als eine Schwellendauer ist.

5. Verfahren nach einem der vorhergehenden Ansprüche, wobei nur Knoten, die in dem Netz in einem Bereich angeordnet sind, der eine direkte PLC-Kommunikation ermöglicht, als einander benachbarte Knoten betrachtet werden.

6. Verfahren nach einem der vorhergehenden Ansprüche, wobei eine Abfolge der Operationen im Laufe der Zeit wiederholt durchgeführt wird, so dass die Anomalieerfassung im Wesentlichen in Echtzeit durchgeführt wird.

7. Verfahren nach einem der vorhergehenden Ansprüche, welches ferner einen vorherigen Schritt des Sendens (101) eines Frames mit breiter Diffusion über das Netz an alle Knoten umfasst.

8. System zur Lokalisierung von Anomalien in einem elektrischen Verteilungsnetz (100), das für die Durchführung des Verfahrens nach einem der vorhergehenden Ansprüche ausgebildet ist, wobei das System eine Mehrzahl von Knoten (1, 2, 3, 4, 5, 6, 8, 12) umfasst, die versehen sind mit:
- Speichermitteln, die dazu ausgebildet sind, in einem Speicher der Knoten einen oder mehrere Sätze von Statusdaten zu speichern, für die jede Statusinformation einem Knoten zugeordnet ist, der dem Knoten benachbart ist, zu dem der Speicher gehört, wobei die Statusdaten von der Erfassung oder Nicht-Erfassung einer Aktivität des benachbarten Knotens durch den Knoten abhängig sind, und
- einem Powerline-Kommunikationsmodul, das die Knoten untereinander und mit einem Konzentratorknoten verbindet, mit dem die Knoten direkt oder indirekt verbunden sind,
wobei der Konzentratorknoten:
- mit einem Powerline-Kommunikationsmodul ausgestattet ist, um mit den Knoten zu kommunizieren,
- dazu ausgebildet ist, Informationen an eine entfernte und mehreren Konzentratorknoten gemeinsame Verarbeitungseinheit zu übertragen, z. B. über ein Mobilfunknetz, und,
- mit einem Modul zur Erfassung einer Anomalie versehen ist, das dazu ausgebildet ist:
a) in dem Konzentratorknoten Sätze von Statusdaten zu sammeln (105), die in einer Mehrzahl von Knoten gespeichert sind,
b) durch Vergleich und Kreuzung der gesammelten Statusdaten Knoten (6) zu identifizieren (109), bei denen die zugeordneten Statusdaten oder die Entwicklung der zugeordneten Statusdaten auf eine fehlende Aktivität hindeuten, und eine wahrscheinliche Lokalisierung einer Anomalie im Netz anhand der identifizierten Knoten und einer Kartographie des Netzes abzuleiten (111).

9. Konzentratorknoten für ein System zur Lokalisierung von Anomalien in einem elektrischen Verteilungsnetz (100) nach Anspruch 8, wobei der Konzentratorknoten umfasst:
- ein Powerline-Kommunikationsmodul, das dazu ausgebildet ist, mit einer Mehrzahl von Knoten des elektrischen Verteilungsnetzes zu kommunizieren, und
- ein Modul zur Erfassung einer Anomalie,
wobei der Konzentratorknoten dazu ausgebildet ist, Informationen an eine entfernte und mehreren Konzentratorknoten gemeinsame Verarbeitungseinheit zu übertragen, z. B. über ein Mobilfunknetz; und
wobei das Modul zur Erfassung einer Anomalie wenigstens einen Prozessor umfasst, der für Folgendes ausgebildet ist:
a) Sammeln (105) von Sätzen von Statusdaten, die in der Mehrzahl von Knoten gespeichert sind, wobei jeder der Sätze in einem entsprechenden Knoten gespeichert ist,
b) durch Kreuzen und Vergleichen der gesammelten Statusdaten, Identifizieren (109) von Knoten (6), bei denen die zugeordneten Statusdaten oder die Entwicklung der zugeordneten Statusdaten auf einen Mangel an Aktivität hinweisen, Ableiten (111) einer wahrscheinlichen Lokalisierung einer Anomalie im Netz aus den identifizierten Knoten und einer Kartographie des Netzes.

10. Computerprogramm, welches Anweisungen umfasst, die das System nach Anspruch 8 dazu veranlassen, die Schritte des Verfahrens nach einem der Ansprüche 1 bis 7 auszuführen.

11. Computerlesbares Medium, auf dem das Computerprogramm nach Anspruch 10 gespeichert ist.

## Claims

1. Method for locating a fault on an electrical distribution network (100) including a plurality of nodes (1, 2, 3, 4, 5, 6, 8, 12) connected directly or indirectly to a concentrator node, each of the nodes in the plurality of nodes being equipped:
- with a powerline communication module able to exchange data with said concentrator node and with one or more adjacent nodes among the plurality of nodes and via the network (100), and
- with a memory able to store data;
the concentrator node comprising:
- a powerline communication module configured to communicate with said nodes, and
- a fault detection module,
the concentrator node being configured to transmit information to a remote processing unit common to a plurality of concentrator nodes, for example via a mobile telephony network;
the method comprising:
a) recording, in the memory of the nodes, one or more sets of state data, for which each state data item is associated with a node adjacent to the node to which the memory belongs, the state data being dependent on the detection or absence of detection by said node of an activity of said adjacent node,
b) collecting (105), in the concentrator node, sets of state data stored in a plurality of nodes, each of the sets being stored in a respective node,
c) by comparison and cross-referencing of the state data collected by the concentrator node, identifying (109), at the concentrator node, nodes (6) for which the associated state data or the change in the associated state data indicates an absence of activity, deducing (111), in the concentrator node or in said remote processing unit common to a plurality of concentrator notes, a probable location of a fault on the network from the nodes identified and from a mapping of said network.

2. Method according to claim 1, wherein each of the state data items is furthermore associated with a date data item.

3. Method according to one of the preceding claims, wherein the state data comprise a value representing a duration of interruption of communication.

4. Method according to one of the preceding claims, wherein the deduction (111) is implemented according to the identified adjacent nodes for which the absence of communication is of a duration greater than a threshold duration.

5. Method according to one of the preceding claims, wherein only the nodes disposed on the network in a zone allowing direct communication by PLC are considered to be nodes adjacent to each other.

6. Method according to one of the preceding claims, wherein a succession of operations is implemented in a manner reiterated over time, so that the fault detection is implemented substantially in real time.

7. Method according to one of the preceding claims, furthermore comprising a prior step of sending (101) over the network a broadcast frame intended for all the nodes.

8. System for locating faults on an electrical distribution network (100) adapted to implement the method of any one of the preceding claims, the system including a plurality of nodes (1, 2, 3, 4, 5, 6, 8, 12) provided:
- with storage means adapted to record, in a memory of the nodes, one or more sets of state data, for which each state data item is associated with a node adjacent to the node to which the memory belongs, the state data being dependent on the detection or absence of detection by said node of an activity of said adjacent node, and
- with a powerline communication module connecting said nodes with each other and with a concentrator node to which said nodes are directly or indirectly connected,
said concentrator node being:
- equipped with a powerline communication module for communicating with said nodes,
- configured to transmit information to a remote processing unit common to a plurality of concentrator nodes, for example via a mobile telephony network, and
- provided with a fault detection module adapted to:
a) collect (105), in the concentrator node, sets of state data stored in a plurality of nodes,
b) by comparison and cross-referencing of the state data collected, identifying (109) nodes (6) for which the associated state data or the change in the associated state data indicates an absence of activity, deducing (111) a probable location of a fault on the network from the nodes identified and from a mapping of said network.

9. Concentrator node for a system for locating faults on an electrical distribution network (100) according to claim 8, the concentrator node comprising:
- a powerline communication module configured to communicate with a plurality of nodes in the electrical distribution network, and
- a fault detection module,
the concentrator node being configured to transmit information to a remote processing unit common to a plurality of concentrator nodes, for example via a mobile telephony network; and
the fault detection module including at least one processor arranged to:
a) collect (105) sets of state data stored in the plurality of nodes, each of the sets being stored in a respective node,
b) by cross-referencing and comparison of the state data collected, identifying (109) nodes (6) for which the associated state data or the change in the associated state data indicates an absence of activity, deducing (111), from the nodes identified and from a mapping of said network, a probable location of a fault on the network.

10. Computer program comprising instructions that lead the system according to claim 8 to implement the steps of the method according to any one of claims 1 to 7.

11. Computer-readable medium on which the computer program according to claim 10 is recorded.
